# EUROPEAN PATENT SPECIFICATION

(11) **EP 3 219 690 B1**
(45) Date of publication and mention of the grant of the patent: **24.04.2019**
(21) Application number: 17158357.8
(22) Date of filing: 28.02.2017
(51) Int. Cl.: C04B 35/01

(54) **LITHIUM COBALT SINTERED BODY AND SPUTTERING TARGET PRODUCED BY USING THE SINTERED BODY, PRODUCTION METHOD OF LITHIUM COBALT OXIDE SINTERED BODY, AND THIN FILM FORMED FROM LITHIUM COBALT OXIDE**
LITHIUM-KOBALT-SINTERKÖRPER UND UNTER VERWENDUNG DES SINTERKÖRPERS HERGESTELLTES SPUTTERTARGET, HERSTELLUNGSVERFAHREN FÜR LITHIUM-KOBALTOXID-SINTERKÖRPER UND AUS LITHIUM-KOBALTOXID GEFORMTE DÜNNSCHICHT
CORPS FRITTÉ À BASE DE COBALT ET DE LITHIUM ET CIBLE DE PULVÉRISATION PRODUITE AU MOYEN DU CORPS FRITTÉ, PROCÉDÉ DE PRODUCTION D'UN CORPS FRITTÉ D'OXYDE DE COBALT ET DE LITHIUM ET FILM MINCE FORMÉ À PARTIR D'OXYDE DE COBALT ET DE LITHIUM

(30) Priority: 17.03.2016 JP 2016053865
(43) Date of publication of application: 20.09.2017
(73) Proprietor: JX Nippon Mining & Metals Corp., Chiyoda-ku Tokyo 1008164 (JP)
(72) Inventor: ENDO, Yosuke, Kitaibaraki-shi, Ibaraki 319-1535 (JP); SATOH, Kazuyuki, Kitaibaraki-shi, Ibaraki 319-1535 (JP); SUZUKI, Ryo, Kitaibaraki-shi, Ibaraki 319-1535 (JP)
(74) Representative: Cornford, James Robert

(56) References cited:
- EP-A1- 2 532 634
- EP-A1- 2 829 636
- EP-A1- 2 975 156
- EP-A1- 2 993 250
- EP-A1- 3 103 894
- US-A1- 2008 073 819

## Description

### [Technical Field]

The present invention relates to a lithium cobalt oxide sintered body and a sputtering target produced by using the sintered body, a method of producing the lithium cobalt oxide sintered body, and a thin film formed from a lithium cobalt oxide, and in particular relates to a sputtering target which is suitable for forming a thin film cathode for use in a thin film battery such as an all-solid battery, and a method of producing such a sputtering target.

### [Background Art]

A lithium ion secondary battery is attracting attention as a high output, large capacity secondary battery, and various R&D activities are being actively conducted. While electrodes and electrolytes configuring the lithium ion secondary battery face numerous challenges from the perspective of energy density, charge-discharge properties, production process, and material costs, an all-solid lithium ion battery which is produced by replacing liquid electrolytes, which are combustible and in which the possibility of fires resulting from a liquid spill is being point out, with solid electrolytes, is attracting attention.

Generally speaking, the ion conductance of solid electrolytes is lower by several orders of magnitude in comparison to liquid electrolytes, and this is a major impediment in the practical application of an all-solid lithium ion battery. And today, numerous research institutions and corporations are actively developing materials concentrating on solid electrolytes having high ionic conductivity. In recent years, an all-solid thin film lithium ion secondary battery which resolved the drawback of having low ionic conductivity has been developed and marketed by forming the solid electrolytes as thin films.

An all-solid thin film battery yields the following characteristics; specifically, it is thin, it can be miniaturized, deterioration is minimal, and there is no problem of a liquid spill. The cathode materials and solid electrode films configuring this type of thin film lithium ion battery are produced via the sputtering method. The sputtering method has advantages in that the adjustment of deposition conditions is easy, and films can be easily deposited on a substrate. The present Applicant has previously provided a technology related to a target formed from a lithium-containing transition metal oxide capable of forming highly uniform films and with minimal generation of particles during sputtering (Patent Document 1).

Various types of research are being conducted for improving the sputtering properties in relation to a target formed from a lithium cobalt oxide and, for instance, Patent Document 2 describes that, by reducing impurities and attaining a relative density of 95% or more and a specific resistance of less than 2 × 107 Ωcm, it is possible to stably deposit films at a high deposition rate without any generation of abnormal discharge. Furthermore, Patent Document 3 describes that, by increasing the area ratio occupied by pores in a large-sized LiCoO₂-containing sputtering target, it is possible to suppress the variation in the specific resistance and deposit films at a high deposition rate.

### [Prior Art Documents]

### [Patent Documents]

[Patent Document 1] Japanese Patent No. 5433044
[Patent Document 2] Japanese Patent Application Publication No. 2013-194299
[Patent Document 3] Japanese Patent Application Publication No. 2014-198901
[Patent Document 4] Japanese Patent Application Publication No. 2014-231639

### SUMMARY OF INVENTION

### [Problems to be Solved by the Invention]

During sputtering, there are cases where cracks (fractures) are generated in a sputtering target due to the high stress that is applied on the target. In particular, since a target for use in rotary sputtering is sputtered at a higher energy in comparison to a conventional planar type target, the stress applied on a rotary target will increase. Thus, a rotary target needs to have high strength in comparison to a planar target. Note that a rotary target refers to a cylindrical target, and is used by bonding to a titanium backing tube or the like, and a planar target refers to a target including a plate shape target and a disk shape target, and is used by being bonded to a copper backing plate or the like.

Nevertheless, the targets described in the foregoing prior art documents are unable to satisfy the required strength, and encountered problems such as the generation of cracks and the increase of particles (microscopic floating materials) during sputtering. Note that, while Patent Document 4 describes a Li-containing oxide target having a bending strength of 20 MPa or more, the highest bonding strength disclosed in its Examples is only 62 MPa, and this level of bending strength is insufficient for rotary sputtering.

Normally, when producing a sintered body (sputtering target) having a high density or high strength, the hot press method is adopted. Even in cases of a cylindrical sputtering target for use in rotary sputtering, considered may be producing the sintered body by placing a powder between a die and a core and performing hot press thereto. Nevertheless, with this method, since the core will become contracted and tightened during the sintering process and cracks will be generated in the sintered body, it was not possible to produce a high strength cylindrical target based on the hot press method. The present invention was devised in order to resolve the foregoing problems, and an object of this invention is to provide a sputtering target having a high strength and capable of stable sputtering, as well as provide a method of producing such a sputtering target and a thin film produced from such a sputtering target.

### [Means for Solving the Problems]

In order to achieve the foregoing object, as a result of intense study, the present inventors discovered that a high strength sputtering target can be obtained by devising the production method in the production process of a sputtering target formed from a lithium cobalt oxide. Based on the foregoing discovery, the present invention provides a lithium cobalt oxide sintered body and a method of producing a lithium cobalt oxide sintered body as claimed.

### [Effect of the Invention]

Because the sputtering target of the present invention formed from a lithium cobalt oxide, which is suitable forming cathode material thin films for use in an all-solid thin film lithium ion secondary battery and the like, is of high strength and enables stable sputtering, it is possible to deposit uniform films. Furthermore, since the sputtering target of the present invention has low bulk resistance and high relative density, it can be used in DC sputtering capable of high-speed deposition, and yields a superior effect of being able to improve the productivity. The present invention is particularly useful in a cylindrical target for use in rotary sputtering.

### BRIEF DESCRIPTION OF DRAWINGS

Fig. 1 is a schematic diagram showing the measurement locations of the bending strength and bulk resistivity of a cylindrical sputtering target.
Fig. 2 is a schematic diagram showing the measurement locations of the bending strength and bulk resistivity of a plate-shaped sputtering target.
Fig. 3 is a schematic diagram showing the measurement locations of the bending strength and bulk resistivity of a disk-shaped sputtering target.

### DETAILED DESCRIPTION

The present invention refers to a lithium cobalt oxide sintered body according to claim 1. The lithium cobalt oxide sintered body of the present invention has a bending strength of 100 MPa or more; preferably 110 MPa or more; and more preferably 120 MPa or more. Since a sputtering target produced using this kind of sintered body having a high strength can inhibit the generation of cracks, it is possible to reduce the generation of abnormal discharge and particles during sputtering, and enable stable sputtering. In particular, this kind of sintered body target having a bending strength of 100 MPa or more (preferably 110 MPa or more or 120 MPa or more) is effective as a cylindrical rotary sputtering target which is demanded of a high strength. Note that, with rotary sputtering, a cylindrical target material (piece) is bonded to a backing tube by being stacked in multiple layers in the longitudinal direction.

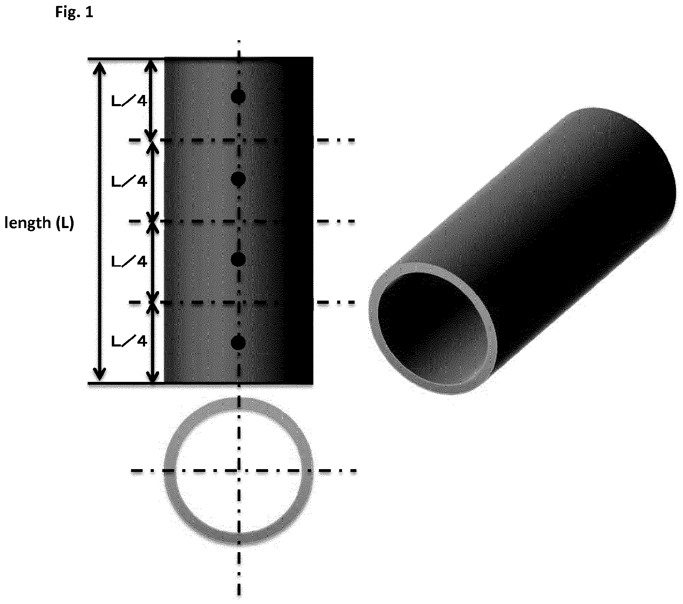

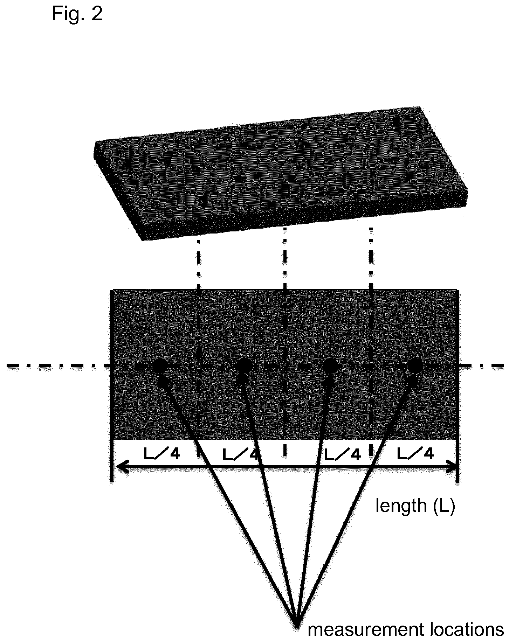

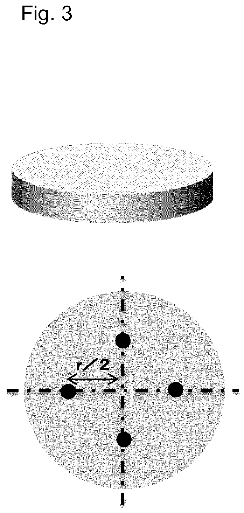

The bending strength in the present invention was measured by cutting test pieces (height: 3.0 (±0.1) mm, width: 4.0 (±0.1) mm, length: 40 mm) from four locations of a target piece as shown in Figs. 1 to 3, and measuring the bending strength of the respective test pieces based on the three-point bending strength measurement method described in JIS R1601, and the average value of the measured values was taken. Note that, in the case of a rotary target, the test pieces were collected so that, of the dimension of the test pieces, the height will be the plate thickness direction and the length will be the longitudinal direction, and, in the case of a planar target, the test pieces were collected so that the height will be the plate thickness direction.

Moreover, with the lithium cobalt oxide sintered body of the present invention, the average value of the bulk resistance is preferably 100 Ω•cm or less, preferably 80 Ω•cm or less; more preferably 50 Ω•cm or less and further preferably 25 Ω•cm or less. A sputtering target produced by using this kind of low resistance sintered body can be applied to DC sputtering which enables stable, high-speed deposition, and can improve the productivity. The bulk resistance in the present invention was measured by measuring four locations of a target piece based on the four-terminal sensing method as shown in Figs. 1 to 3, and the average value of the measured values was taken.

The lithium cobalt oxide sintered body (true density: 5.05g/cm³) of the present invention has a relative density (measured density/true density × 100) of 87% or more, and more preferably a relative density of 90% or more. A sputtering target produced by using this kind of high density sintered body enables stable sputtering which is free from abnormal discharge. Moreover, a high density target can be used in DC sputtering which enables high-speed deposition in combination with the foregoing resistance value of the target, and thereby improve the productivity. In the present invention, the measured density of the sintered body was measured based on the Archimedes method. Note that, while a higher density is preferable, in effect, the upper limit thereof is roughly 94%, thus preferable ranges are a relative density of 87% to 94%, more preferably 89% to 92%.

The lithium cobalt oxide sintered body (or sputtering target) of the present invention is of a cylindrical shape for use in rotary sputtering. The sintered body (or sputtering target) of the present invention is able to achieve high strength, low resistance, and high density even when formed in this kind of cylindrical shape, and the high strength sintered body in the present invention is particularly effective as a cylindrical target for use in rotary sputtering.

The lithium cobalt oxide sintered body of the present invention can be produced as follows. Foremost, water and PVA (polyvinyl alcohol) are added to a lithium cobalt oxide raw material powder having a predetermined LiCo ratio to prepare a lithium cobalt oxide slurry. Next, the lithium cobalt oxide slurry (containing PVA) is spray-dried to prepare a granulated powder having an average grain size of 20 to 150 µm. Here, when the average grain size is less than 20 µm, it is difficult for the density of the molded body to increase after processes such as cold press and CIP, and, because the powder is light, there are cases where the yield during granulation becomes inferior. Meanwhile, when the average grain size exceeds 150 µm, the density of the molded by after processes such as cold press and CIP may deteriorate, and this is undesirable.

Next, the obtained granulated powder is subject to cold press and/or CIP (cold isostatic press) to prepare a molded body. In particular, when forming a cylindrical shape, the granulated powder is preferably subject to CIP molding to obtain a molded body, and when forming a plate shape, the granulated powder is preferably subject to cold press and thereafter subject to CIP molding to obtain a molded body. Here, the pressure is preferably 20 to 50 MPa in the case of performing cold press, and the pressure is preferably 100 to 170 MPa when performing CIP.

Next, the molded body of the lithium cobalt oxide obtained as described above is sintered at 1000°C to 1100°C in an oxygen atmosphere to prepare a sintered body. When the sintering temperature is less than 1000°C, the density of the sintered body cannot be increased. Meanwhile, when the sintering temperature exceeds 1100°C, the lithium cobalt oxide will decompose and cause the bending strength of the sintered body to deteriorate and cause the bulk resistance to increase, and this is undesirable. By performing sintering within the foregoing optimal temperature range, it is possible to obtain a high strength lithium cobalt oxide sintered body. Moreover, the sintering time is preferably 20 hours or more and 40 hours or less. When the sintering time is less than 20 hours, sintering will not progress sufficiently, and when the sintering time exceeds 40 hours, the decomposition of the lithium cobalt oxide may progress.

After subjecting the thus obtained sintered body to machining (cutting, polishing or the like) to obtain a target shape, it is bonded to a backing plate in a disk shape or a plate shape; or to a backing tube in a cylindrical shape to prepare a sputtering target assembly. Thereafter, the surface of the target to be sputtered is subject to cutting or grinding by a thickness of 0.1 to 1.0 mm to remove the altered layer, whereby the target is finished.

### [Examples]

The present invention is now explained based on Examples and Comparative Examples. Note that the following Examples are merely exemplifications, and the present invention is not limited to such Examples. In other words, the scope of the present invention is limited only by the claims, and the present invention also covers the other modes and modifications included therein.

### (Example 1)

Water and PVA were added to a lithium cobalt oxide raw material powder to attain a solid content of 50 mass% and prepare a lithium cobalt oxide slurry. Next, the prepared lithium cobalt oxide slurry was dried with a spray dryer to obtain a granulated powder having an average grain size of 50 µm. Subsequently, the obtained granulated powder was subject to CIP molding at a pressure of 120 MPa, and the obtained molded body was sintered at 1000°C for 30 hours in an oxygen atmosphere to prepare a cylindrical sintered body formed from a lithium cobalt oxide having an outer diameter of 160 mm, an inner diameter of 130 mm, and a length of 260 mm.

As a result of measuring the bending strength of the obtained sintered body with a tensile and compression testing machine (manufactured by Imada-SS Corporation, model SV-201 NA-50SL), the average value of the bending strength was 105 MPa. Moreover, the relative density of the sintered body was 87%. Next, a sintered body prepared according to the same method was subject to cutting work and finished as a cylindrical target piece having an outer diameter of 151 mm, an inner diameter of 135 mm, and a length of 240 mm. As a result of measuring the bulk resistivity of this target piece, the average value was 11 Ω•cm. Subsequently, a total of six cylindrical target pieces were bonded to a titanium backing tube, a thickness of 0.5 mm was cut in order to remove the surface altered layer that was altered during bonding, and the bonded product was mounted on a sputtering device and sputtered. Consequently, DC sputtering was possible, arcing was not generated, and stable deposition was enabled. The foregoing results are shown in Table 1.

**[Table 1]**

| | Sintering | Shape | Sintering Temperature [°C] | Sintering Time [h] | Pressure [kgf/cm²] | Sintered Body Size [mm] | Atmosphere | Relative Density [%] | Average Bulk Resistance [Ω·cm] | Bending Strength [Mpa] | DC Sputtering |
|---|---|---|---|---|---|---|---|---|---|---|---|
| Example 1 | Pressureless sintering | Cylinder | 1000 | 30 | - | O.D.ϕ160 x I.D.ϕ130 x 260L | Oxygen | 87 | 11 | 105 | ○ |
| Example 2 | Pressureless sintering | Cylinder | 1050 | 30 | - | O.D.ϕ160 x I.D.ϕ130 x 260L | Oxygen | 90 | 19 | 125 | ○ |
| Example 3 | Pressureless sintering | Cylinder | 1100 | 30 | - | O.D.ϕ160 x I.D.ϕ130 x 260L | Oxygen | 94 | 97 | 118 | ○ |
| Example 4 | Pressureless sintering | Cylinder | 1050 | 20 | - | O.D.ϕ160 x I.D.ϕ130 x 260L | Oxygen | 89 | 17 | 117 | ○ |
| Example 5 | Pressureless sintering | Cylinder | 1050 | 40 | - | O.D.ϕ160 x I.D.ϕ130 x 260L | Oxygen | 91 | 22 | 123 | ○ |
| Example 6 | Pressureless sintering | Cylinder | 1050 | 30 | - | O.D.ϕ160 x I.D.ϕ130 x 400L | Oxygen | 90 | 27 | 123 | ○ |
| Example 7 | Pressureless sintering | Disk | 1050 | 30 | - | ϕ220 x 12t | Oxygen | 89 | 20 | 124 | ○ |
| Comparative Example 1 | Hot press | Disk | 950 | 2 | 300 | ϕ220 x 12t | Vacuum | 95 | 270 | 57 | × |
| Comparative Example 2 | Hot press | Disk | 1050 | 2 | 300 | ϕ220 x 12t | Vacuum | 96 | 1106 | 53 | × |
| Comparative Example 3 | Pressureless sintering | Cylinder | 1200 | 30 | - | O.D.ϕ160 x I.D.ϕ130 x 260L | Oxygen | 94 | 1256 | 90 | × |
| Comparative Example 4 | Pressureless sintering | Cylinder | 950 | 30 | - | O.D.ϕ160 x I.D.ϕ130 x 260L | Oxygen | 86 | 11 | 93 | ○ |

### (Examples 2 to 6)

In the same manner as Example 1, water and PVA were added to a lithium cobalt oxide raw material powder to attain a solid content of 50 mass% and prepare a lithium cobalt oxide slurry. Next, the prepared lithium cobalt oxide slurry was dried with a spray dryer to obtain a granulated powder having an average grain size of 50 µm. Subsequently, the obtained granulated powder was subject to CIP molding at a pressure of 120 MPa, and the obtained molded body was sintered in an oxygen atmosphere to prepare a cylindrical sintered body formed from a lithium cobalt oxide having an outer diameter of 160 mm, an inner diameter of 130 mm, and a length of 260 mm (Example 6 had a length of 400 mm). In Examples 2 to 6, sintered bodies were prepared by changing the sintering temperature and the sintering time as shown in Table 1.

As a result of measuring the bending strength of the obtained sintered body in the same manner as Example 1, the average value of the bending strength was 100 MPa in all cases. Moreover, the relative density of the sintered body was 87% or more in all cases. Next, sintered bodies prepared according to the same method were subject to cutting work and finished as cylindrical target pieces having an outer diameter of 151 mm, an inner diameter of 135 mm, and a length of 240 mm. As a result of measuring the bulk resistivity of the target pieces, the average value was 100 Ω•cm or less in all cases. Subsequently, six cylindrical target pieces were bonded to a titanium backing tube, a thickness of 0.5 mm was cut in order to remove the surface altered layer that was altered during bonding, and the bonded product was mounted on a sputtering device and sputtered. Consequently, DC sputtering was possible, arcing was not generated, and stable deposition was enabled in all cases.

### (Example 7)

In the same manner as Example 1, water and PVA were added to a lithium cobalt oxide raw material powder to attain a solid content of 50 mass% and prepare a lithium cobalt oxide slurry. Next, the prepared lithium cobalt oxide slurry was dried with a spray dryer to obtain a granulated powder having an average grain size of 50 µm. Next, the obtained granulated powder was subject to cold press at a pressure of 25 MPa and thereafter subject to CIP molding at a pressure of 150 MPa to prepare a molded body. Subsequently, the obtained molded body was sintered at 1050°C and for 30 hours in an oxygen atmosphere to prepare a disk-shaped sintered body formed from a lithium cobalt oxide having a diameter of 220 mm and a thickness of 12 mm.

As a result of measuring the bending strength of the obtained sintered body in the same manner as Example 1, the average value of the bending strength was 124 MPa. Moreover, the relative density of the sintered body was 89%. Next, a sintered body prepared according to the same method was subject to cutting work and finished as a disk-shaped target having a diameter of 203.5 mm and a thickness of 5.5 mm. As a result of measuring the bulk resistivity of the target, the average value was 20 Ω•cm. Subsequently, the disk-shaped target was bonded to a copper backing plate, a thickness of 0.5 mm was cut in order to remove the surface altered layer that was altered during bonding, and the bonded product was mounted on a sputtering device and sputtered. Consequently, DC sputtering was possible, arcing was not generated, and stable deposition was enabled.

### (Comparative Examples 1 and 2)

In the same manner as Example 1, water and PVA were added to a lithium cobalt oxide raw material powder to attain a solid content of 50 mass% and prepare a lithium cobalt oxide slurry. Next, the prepared lithium cobalt oxide slurry was dried with a spray dryer to obtain a granulated powder having an average grain size of 50 µm. Subsequently, the obtained granulated powder was filled in a carbon mold and subject to hot press sintering under the following conditions; specifically, in a vacuum, at 950°C (Comparative Example 1) or 1050°C (Comparative Example 2), for 2 hours, and at a pressure of 300 kgf/cm² (29.5 MPa) to prepare a disk-shaped sintered body formed from a lithium cobalt oxide having a diameter of 220 mm and a thickness of 12 mm.

As a result of measuring the bending strength of the obtained sintered body in the same manner as Example 1, the average values of the bending strength were low values at 57 MPa and 53 MPa, respectively. Next, sintered bodies prepared according to the same method were subject to cutting work and finished as disk-shaped targets having a diameter of 203.5 mm and a thickness of 5.5 mm. As a result of measuring the bulk resistivity of the targets, the average value considerably exceeded 100 Ω•cm in all cases. Subsequently, the disk-shaped targets were bonded to a copper backing plate, a thickness of 0.5 mm was cut in order to remove the surface altered layer that was altered during bonding, and the bonded product was mounted on a sputtering device and sputtered. Consequently, DC sputtering was not possible or discharge was unstable, and stable deposition could not be performed.

### (Comparative Examples 3 and 4)

In the same manner as Example 1, water and PVA were added to a lithium cobalt oxide raw material powder to attain a solid content of 50 mass% and prepare a lithium cobalt oxide slurry. Next, the prepared lithium cobalt oxide slurry was dried with a spray dryer to obtain a granulated powder having an average grain size of 50 µm. Subsequently, the obtained granulated powder was subject to CIP molding at a pressure of 120 MPa, and the obtained molded body was sintered in an oxygen atmosphere to prepare a cylindrical sintered body formed from a lithium cobalt oxide having an outer diameter of 160 mm, an inner diameter of 130 mm, and a length of 260 mm. In Comparative Examples 3 and 4, sintered bodies were prepared by changing the sintering temperature and sintering time as shown in Table 1.

As a result of measuring the bending strength of the obtained sintered body in the same manner as Example 1, the average value of the bending strength was less than 100 MPa in all cases. Moreover, the relative density of the sintered body of Comparative Example 4 showed a low value at 86%. Next, sintered bodies prepared according to the same method were subject to cutting work and finished as cylindrical target pieces having an outer diameter of 151 mm, an inner diameter of 135 mm, and a length of 240 mm. As a result of measuring the bulk resistivity of the target piece, the average value of resistivity in Comparative Example 3 showed a high value at 1256 Ω•cm. Subsequently, six cylindrical target pieces were bonded to a titanium backing tube, a thickness of 0.5 mm was cut in order to remove the surface altered layer that was altered during bonding, and the bonded product was mounted on a sputtering device and sputtered. Consequently, DC sputtering was not possible, or stable deposition was not possible.

### [Industrial Applicability]

Because the lithium cobalt oxide sintered body and the sputtering target formed using the sintered body of the present invention are of high strength, hardly any cracks are generated, and they yield favorable sputtering characteristics. Moreover, since the sputtering target of the present invention has low resistivity and can be subject to DC sputtering, it is possible to deposit uniform thin films at a high rate. Moreover, since the sputtering target of the present invention has a high density, the generation of abnormal discharge (arcing) during deposition is minimal, and the generation of particles can be inhibited. An all-solid thin film lithium ion secondary battery adopting this kind of thin film yields an effect of being able to obtain stable charge-discharge characteristics. The present invention is particularly useful in a lithium ion secondary battery for use in vehicles, telecommunication equipment, household equipment and solar batteries.

When used in this specification and claims, the terms "comprises" and "comprising" and variations thereof mean that the specified features, steps or integers are included. The terms are not to be interpreted to exclude the presence of other features, steps or components.

The features disclosed in the foregoing description, or the following claims, or the accompanying drawings, expressed in their specific forms or in terms of a means for performing the disclosed function, or a method or process for attaining the disclosed result, as appropriate, may, separately, or in any combination of such features, be utilised for realising the invention in diverse forms thereof. In particular, one or more features in any of the embodiments described herein may be combined with one or more features from any other embodiments described herein.

## Claims

1. A lithium cobalt oxide sintered body, wherein the sintered body has a bending strength of 100 MPa or more and a relative density of 87% or more and is of a cylindrical shape.

2. The lithium cobalt oxide sintered body according to claim 1, wherein the sintered body has a bending strength of 110 MPa or more, preferably 120 MPa or more.

3. The lithium cobalt oxide sintered body according to claim 1 or 2, wherein an average value of a bulk resistance of the sintered body is 100 Ω•cm or less.

4. The lithium cobalt oxide sintered body according to claim 3, wherein an average value of the bulk resistance of the sintered body is 80 Ω•cm or less, preferably 50 Ω•cm or less, more preferably 25 Ω•cm or less.

5. The lithium cobalt oxide sintered body according to any preceding claim, wherein the sintered body has a relative density 90% or more.

6. The lithium cobalt oxide sintered body according to any preceding claim, wherein the sintered body has a relative density of 87% to 94%, preferably 89% to 92%.

7. A sputtering target formed using the sintered body according to any one of claims 1 to 6.

8. A method of producing a lithium cobalt oxide sintered body, comprising:
spray-drying a lithium cobalt oxide slurry to obtain a granulated powder having an average grain size of 20 to 150 µm;
cold pressing the granulated powder at a pressure of 20 to 50 MPa and/or CIP molding the granulated powder at a pressure of 100 to 170 MPa to obtain a molded body; and
sintering the molded body at 1000 to 1100°C for 20 hours or more and 40 hours or less in an atmosphere containing oxygen in an amount of 99 vol% or more.

9. The method of claim 8, wherein the granulated powder is CIP molded at a pressure of 100 to 170 MPa to obtain a cylindrical body.

10. The method of claim 8 or 9, wherein the granulated powder is cold pressed at a pressure of 20 to 50 MPa and thereafter CIP molded at a pressure of 100 to 170 MPa to obtain a plate-shaped body.

11. A method of producing a sputtering target, wherein the lithium cobalt oxide sintered body produced with the method according to any one of claims 8 to 10 is machined into a target shape and thereafter bonded to a backing plate or a backing tube, and a surface to be sputtered of the sputtering target is subject to cutting or grinding, preferably by a thickness of 0.1 to 1.0 mm.

## Patentansprüche

1. Lithium-Kobaltoxid-Sinterkörper, worin der Sinterkörper eine Biegefestigkeit von 100 MPa oder mehr und eine relative Dichte von 87 % oder mehr und eine zylindrische Form aufweist.

2. Lithium-Kobaltoxid-Sinterkörper nach Anspruch 1, worin der Sinterkörper eine Biegefestigkeit von 110 MPa oder mehr, bevorzugt 120 MPa oder mehr, aufweist.

3. Lithium-Kobaltoxid-Sinterkörper nach Anspruch 1 oder 2, worin ein Durchschnittswert eines Materialwiderstands des Sinterkörpers 100 Ω•cm oder weniger beträgt.

4. Lithium-Kobaltoxid-Sinterkörper nach Anspruch 3, worin ein Durchschnittswert des Materialwiderstands des Sinterkörpers 80 Ω•cm oder weniger, bevorzugt 50 Ω•cm oder weniger, bevorzugter 25 Ω•cm oder weniger, beträgt.

5. Lithium-Kobaltoxid-Sinterkörper nach einem vorhergehenden Anspruch, worin der Sinterkörper eine relative Dichte von 90 % oder mehr aufweist.

6. Lithium-Kobaltoxid-Sinterkörper nach einem vorhergehenden Anspruch, worin der Sinterkörper eine relative Dichte von 87 % bis 94 %, bevorzugt 89 % bis 92 %, aufweist.

7. Sputtertarget, das unter Verwendung des Sinterkörpers nach einem der Ansprüche 1 bis 6 geformt wird.

8. Verfahren zur Herstellung eines Lithium-Kobaltoxid-Sinterkörpers, umfassend:
Sprühtrocknen einer Lithium-Kobaltoxid-Aufschlämmung, um ein granuliertes Pulver mit einer durchschnittlichen Korngröße von 20 bis 150 µm zu erhalten;
Kaltpressen des granulierten Pulvers bei einem Druck von 20 bis 50 MPa und/oder CIP-Formen des granulierten Pulvers bei einem Druck von 100 bis 170 MPa, um einen geformten Körper zu erhalten; und
Sintern des geformten Körpers bei 1000 bis 1100 °C für 20 Stunden oder mehr und 40 Stunden oder weniger in einer Atmosphäre, die Sauerstoff in einer Menge von 99 Vol.-% oder mehr enthält.

9. Verfahren nach Anspruch 8, worin das granulierte Pulver bei einem Druck von 100 bis 170 MPa CIP-geformt wird, um einen zylindrischen Körper zu erhalten.

10. Verfahren nach Anspruch 8 oder 9, worin das granulierte Pulver bei einem Druck von 20 bis 50 MPa kaltgepresst und danach bei einem Druck von 100 bis 170 MPa CIP-geformt wird, um einen plattenförmigen Körper zu erhalten.

11. Verfahren zur Herstellung eines Sputtertargets, worin der mit dem Verfahren nach einem der Ansprüche 8 bis 10 hergestellte Lithium-Kobaltoxid-Sinterkörper zu einer Targetform verarbeitet und danach an eine Stützplatte oder ein Stützrohr gebondet wird und eine zu sputternde Oberfläche des Sputtertargets dem Schneiden oder Schleifen, bevorzugt um eine Dicke von 0,1 bis 1,0 mm, unterzogen wird.

## Revendications

1. Corps fritté d'oxyde de lithium cobalt, dans lequel le corps fritté a une résistance à la flexion de 100 MPa et une densité relative de 87 % et est de forme cylindrique.

2. Corps fritté d'oxyde de lithium cobalt selon la revendication 1, dans lequel le corps fritté a une résistance à la flexion égale ou supérieure à 110 MPa, de préférence égale ou supérieure à 120 MPa.

3. Corps fritté d'oxyde de lithium cobalt selon la revendication 1 ou 2, dans lequel une valeur moyenne de résistance volumique du corps fritté est égale ou inférieure à 100 Q*cm.

4. Corps fritté d'oxyde de lithium cobalt selon la revendication 3, dans lequel une valeur moyenne de la résistance volumique du corps fritté est égale ou inférieure à 80 Q*cm, de préférence égale ou inférieure à 50 Q*cm, plus préférablement égale ou inférieure à 25 Q*cm.

5. Corps fritté d'oxyde de lithium cobalt selon l'une quelconque des revendications précédentes, dans lequel le corps fritté a une densité relative égale ou supérieure à 90 %.

6. Corps fritté d'oxyde de lithium cobalt selon l'une quelconque des revendications précédentes, dans lequel le corps fritté a une densité relative comprise entre 87 % et 94 %, de préférence comprise entre 89 % et 92 %.

7. Cible de pulvérisation formée en utilisant le corps fritté selon l'une quelconque des revendications 1 à 6.

8. Procédé de fabrication d'un corps fritté d'oxyde de lithium cobalt, consistant à :
sécher par pulvérisation une suspension épaisse d'oxyde de lithium cobalt pour obtenir une poudre granulée ayant une taille de grain moyenne comprise entre 20 et 150 µm ;
presser à froid la poudre granulée à une pression comprise entre 20 et 50 MPa et/ou mouler par pressage isostatique à froid (CIP) la poudre granulée à une pression comprise entre 100 et 170 MPa pour obtenir un corps moulé ; et
fritter le corps moulé entre 1000 et 1100°C pendant 20 heures ou plus et 40 heures ou moins dans une atmosphère contenant de l'oxygène dans une quantité égale ou supérieure à 99 % en volume.

9. Procédé selon la revendication 8, dans lequel la poudre granulée est moulée par pressage isostatique à froid (CIP) à une pression comprise entre 100 et 170 MPa pour obtenir un corps cylindrique.

10. Procédé selon la revendication 8 ou 9, dans lequel la poudre granulée est pressée à froid à une pression comprise entre 20 et 50 MPa et ensuite moulée par pressage isostatique à froid (CIP) à une pression comprise entre 100 et 170 MPa pour obtenir un corps en forme de plaque.

11. Procédé de fabrication d'une cible de pulvérisation, dans lequel le corps fritté d'oxyde de lithium cobalt produit avec le procédé selon l'une quelconque des revendications 8 à 10 est usiné en forme de cible et ensuite collé à une plaque de support ou à un tube de support, et une surface à pulvériser de la cible de pulvérisation est soumise à une découpe ou un meulage, de préférence d'une épaisseur comprise entre 0,1 et 1,0 mm.
